# EUROPEAN PATENT APPLICATION

(11) **EP 3 876 512 A1**
(43) Date of publication of application: **08.09.2021**
(21) Application number: 18939125.3
(22) Date of filing: 31.10.2018
(51) Int. Cl.: H04N 5/225, B64D 47/08, G05D 1/08

(54) **CIRCUIT BOARD SYSTEM, PHOTOGRAPHING DEVICE, GIMBAL ASSEMBLY, AND MOVABLE PLATFORM**

(71) Applicant: SZ DJI Technology Co., Ltd., Shenzhen, Guangdong 518057 (CN)
(72) Inventor: DU, Jun, Shenzhen, Guangdong 518057 (CN); LIU, Yucheng, Shenzhen, Guangdong 518057 (CN); ZHANG, Haining, Shenzhen, Guangdong 518057 (CN)
(74) Representative: Appelt, Christian W.
(86) International application number: PCT/CN2018/113176
(87) International publication number: WO 2020/087392

(57) **Abstract**

A circuit board system, a photographing device, a gimbal assembly, and a movable platform. The circuit board system (100) is configured to be fixed at an inner frame of a gimbal (300). The circuit board system (100) includes one or more first circuit boards (110) and a second circuit board (120). Each first circuit board (110) is configured to be connected to at least one input/output assembly (200) capable of receiving/transmitting optical signal. The second circuit board (120) is disposed independently from the one or more first circuit boards (110). The second circuit board (120) is provided with an inertial measurement unit (130), a first interface (140), and one or more second interfaces (150). The one or more second interfaces (150) are correspondingly electrically connected to the one or more first circuit boards (110). The second circuit board (120) is configured to supply power to the one or more first circuit boards (110). The inertial measurement unit (130) is electrically connected to the first interface (140). The first interface (140) is configured to be electrically connected to a main control circuit board (310) of the gimbal.

## Description

### TECHNICAL FIELD

The present disclosure relates to the field of circuit boards and, more particularly, to a circuit board system, a photographing device, a gimbal assembly, and a movable platform.

### BACKGROUND

In an existing camera used with a gimbal, an inertial measurement unit is integrated on a circuit board connected with a camera module. Since the ideal operating temperature of the inertial measurement unit is about 60 Celsius degrees and the normal operating temperature of the camera module is much lower than 60 Celsius degrees, the operating temperature of the inertial measurement unit makes the camera module unable to work normally. Generally, in the existing technologies, to ensure that the working performance of the camera module meets the use requirements, a part of the performance of the inertial measurement unit is sacrificed. Correspondingly, it is difficult to achieve the best performance in existing products. Moreover, in an existing circuit board structure, spatial layouts of the inertial measurement unit and the camera module also largely restrict and affect each other, resulting in restrictions on installation positions of the inertial measurement unit and the camera module, which is not conducive to the rationality of the internal spatial layout of the product.

### SUMMARY

In view of the above, there is a need to provide a circuit board system that can solve at least one of the above technical problems.

One aspect of the present disclosure provides a circuit board system configured to be fixed at an inner frame of a gimbal. The circuit board system includes one or more first circuit boards, and a second circuit board. Each first circuit board of the one or more first circuit boards is configured to be connected to at least one input/output assembly capable of receiving/transmitting optical signal. The second circuit board is disposed independently from the one or more first circuit boards. The second circuit board is provided with an inertial measurement unit, a first interface, and a plurality of second interfaces. The plurality of second interface are correspondingly electrically connected to the one or more first circuit boards. The second circuit board is configured to supply power to the one or more first circuit boards. The inertial measurement unit is electrically connected to the first interface; and the first interface is configured to be electrically connected to a main control circuit board of the gimbal.

Another aspect of the present disclosure provides a photographing device. The photographing device includes a circuit board system provided by any technical solutions of the first aspect of the present disclosure. The input/output assemblies connected to the one or more first circuit boards of the circuit board system at least include an imaging assembly.

Another aspect of the present disclosure provides a gimbal assembly. The gimbal assembly includes a gimbal and a circuit board system provided by any technical solutions of the first aspect of the present disclosure.

Another aspect of the present disclosure provides a movable platform. The movable platform includes a vehicle body and a gimbal assembly provided by any technical solutions of the third aspect of the present disclosure. The gimbal of the gimbal assembly is connected to the vehicle body.

Compared to the existing technology, the present disclosure has following benefits.

In the circuit board system provided by the present disclosure, the second circuit board and the one or more first circuit boards are arranged independently. Therefore, the mutual interference between the input/output assemblies electrically connected to the one or more first circuit boards and the inertial measurement unit can be greatly reduced. Further, the spatial location layout of the inertial measurement unit and the input/output assemblies is not limited to the same circuit board. As such, the location layout of the inertial measurement unit and the input/output assemblies can be more flexible, and more space can be provided near the inertial measurement unit to handle the external interference to and working environment requirements of the inertial measurement unit. Performance of the inertial measurement unit and the input/output assemblies can be improved, and the comprehensive improvement of product performance can be promoted. Further, the workload of hardware development can be reduced, thermal load on the input/output assembly can be reduced, the compact and reasonable space layout among product components can be improved, which is conducive to the development of miniaturization and light weight of the product. Further, by separating the second circuit board with the inertial measurement unit from the one or more first circuit boards that are electrically connected to the input/output assemblies, the inertial measurement unit can be maintained and replaced more conveniently. For example, when the inertial measurement unit is damaged, the second circuit board can be replaced without the need to also replace or disassemble input/output assemblies. The maintenance cost can be lower, and the product maintenance can be improved.

Additional aspects and advantages of the present disclosure will become apparent in the following description, or be understood through the practice of the present disclosure.

### BRIEF DESCRIPTION OF THE DRAWINGS

The above and/or additional aspects and advantages of the present disclosure will become obvious and easy to understand from the description of the embodiments in conjunction with the following drawings.
FIG. 1 is a structural diagram of a circuit board system consistent with an embodiment of the present disclosure.
FIG. 2 is a structural diagram of a circuit board system consistent with an embodiment of the present disclosure.
FIG. 3 is a structural diagram of a circuit board system consistent with an embodiment of the present disclosure.
FIG. 4 is a structural diagram of a circuit board system consistent with an embodiment of the present disclosure.
FIG. 5 is a structural diagram of a circuit board system consistent with an embodiment of the present disclosure.
FIG. 6 is a partial structural diagram of a circuit board system consistent with an embodiment of the present disclosure.
FIG. 7 is a partial cross-sectional structural diagram of a circuit board system consistent with an embodiment of the present disclosure.
FIG. 8 is another partial cross-sectional structural diagram of a circuit board system consistent with an embodiment of the present disclosure.
FIG. 9 is an exploded structural diagram of a circuit board system consistent with an embodiment of the present disclosure.
FIG. 10 is an exploded structural diagram of a circuit board system consistent with an embodiment of the present disclosure.
FIG. 11 is a partial structural diagram of a circuit board system consistent with an embodiment of the present disclosure.
FIG. 12 is a structural diagram of a front housing consistent with an embodiment of the present disclosure.
FIG. 13 is a partial structural diagram of a circuit board system consistent with an embodiment of the present disclosure.
FIG. 14 is a structural diagram of a gimbal assembly consistent with an embodiment of the present disclosure.
FIG. 15 is a structural diagram of the gimbal assembly in FIG. 14 from another view angle.

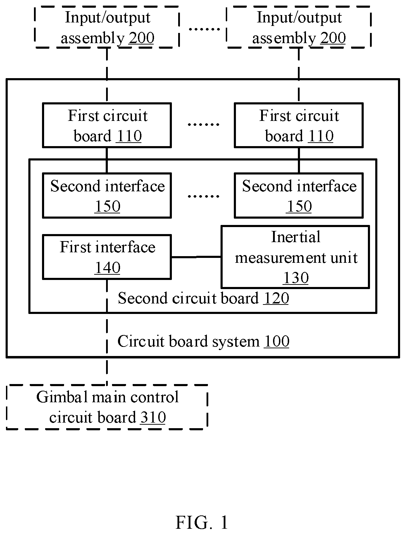

Correspondences between reference numerals in FIGs. 1-15 and names of components are as follows:

| | |
|---|---|
| Circuit board system | 100 |
| First circuit board | 110 |
| Mobile industry processor interface (MIPI) | 1102 |
| Target circuit board | 112 |
| Serial peripheral interface (SPI) | 1122 |
| Second circuit board | 120 |
| Inertial measurement unit | 130 |
| First interface | 140 |
| Second interface | 150 |
| Functional circuit | 160 |
| Power supply circuit | 162 |
| Clock circuit | 164 |
| Voltage conversion circuit | 166 |
| Housing | 170 |
| Front housing | 172 |
| Positioning post | 1722 |
| Fixing groove | 1724 |
| Screw hole | 1726 |
| Rear housing | 174 |
| Middle frame | 176 |
| Positioning groove | 1762 |
| Heat sink | 180 |
| Flat cable | 190 |
| Input/output assembly | 200 |
| Lens | 211 |
| Lens frame | 212 |
| Sealing ring | 213 |
| Thermal imaging assembly | 220 |
| Visible light imaging assembly | 230 |
| Gimbal | 300 |
| Gimbal main control circuit board | 310 |
| Movable platform main control board | 400 |

### DETAILED DESCRIPTION OF THE EMBODIMENTS

In order for the above objectives, features, and advantages of the present disclosure to be better understood, the present disclosure will be further described in detail below with reference to the accompanying drawings and specific embodiments. It should be noted that the embodiments of the application and the features in the embodiments can be combined with each other as long as there is no conflict.

In the following description, many specific details are set forth in order to fully understand the present disclosure. However, the present disclosure can also be implemented in other ways different from those described here. Therefore, the scope of the present disclosure is not limited to the specific embodiments disclosed below.

A circuit board system and a gimbal assembly according to some embodiments of the present disclosure are described below with reference to FIG. 1 to FIG. 15.

Embodiments of the first aspect of the present disclosure provide a circuit board system 100 as illustrated in FIG. 1 to FIG. 13. The circuit board system 100 is configured to be fixed at an inner frame of a gimbal 300. Those skilled in the art can understand that the gimbal 300 may be a product used to carry and drive a load to move. The inner frame of the gimbal 300 may be a component of the gimbal 300 used to be connected to the load. The circuit board system 100 in this design may be configured to be fixed at the inner frame of the gimbal 300 such that the circuit board system 100 can be mounted at the gimbal 300 and used as a load. According to specific usage requirements, the circuit board system 100 and the inner frame of the gimbal 300 can be selectively designed to be detachably fixed to each other or designed to be non-detachably fixed to each other.

As illustrated in FIG. 1 to FIG. 5, the circuit board system 100 includes: one or more first circuit boards 110 and a second circuit board 120. Each first circuit board 110 of the one or more first circuit boards 110 may be configured to be connected to to at least one input/output assembly 200 which is capable of receiving/transmitting optical signals. The second circuit board 120 is disposed independently to the one or more first circuit boards 110, and is provided with an inertial measurement unit 130, a first interface 140, and a plurality of second interfaces 150. The plurality of second interfaces 150 are correspondingly electrically connected to the one or more first circuit boards 110. The second circuit board 120 is used to supply power to the one or more first circuit boards 110. The inertial measurement unit 130 is electrically connected to the first interface 140, and the first interface 140 is configured to be electrically connected to a main control circuit board 310 of the gimbal.

The one or more first circuit boards 110 may include one first circuit board 110, or more than one first circuit board 110.

It should be noted that positional relationships among modules in the second circuit board 120 (such as relative positional relationship among the second interfaces, the first interface, the power supply circuit, the voltage conversion circuit, the inertial measurement unit, and other modules) shown in FIG. 1 to FIG. 5 should not limit the scopes of the present disclosure.

It is understandable that the input/output assembly 200 being capable of receiving/transmitting optical signals should be understood as: the input/output assembly 200 is an assembly capable of receiving optical signals and/or transmitting optical signals. That the second circuit board 120 and the one or more first circuit boards 110 are arranged independently means that the second circuit board 120 and the one or more first circuit boards 110 are independent in position. The second circuit board 120 and the one or more first circuit boards 110 can be installed in the same device or in different devices.

In the circuit board system 100 provided by the above-mentioned embodiments of the present disclosure, the second circuit board 120 and the one or more first circuit boards 110 are arranged independently. Correspondingly, mutual interference between the input/output assembly 200 electrically connected to the one or more first circuit boards 110 and the inertial measurement unit 130 may be reduced significantly. Moreover, the spatial location layout of the inertial measurement unit 130 and the input/output assembly 200 may be not limited to the same circuit board. In this way, the location layout between the inertial measurement unit 130 and the input/output assembly 200 can be more flexible, especially for the case where the number of the input/output assemblies 200 is multiple. Therefore, more space can be provided near the inertial measurement unit 130 to handle the external interference and working environment requirements of the inertial measurement unit 130, which is beneficial to the performance of the inertial measurement unit 130 and the input/output assembly 200 and promote the comprehensive improvement of product performance. At the same time, the workload of hardware development man be alleviated, and the heat dissipation load on the input/output assembly 200 may be reduced. A compact and reasonable space layout between the product components may be facilitated. The miniaturization and lightweight development of the product may be improved. Further, by separating the second circuit board 120 provided with the inertial measurement unit 130 from the one or more first circuit boards 110 for electrical connection with the input/output assembly 200, the inertial measurement unit 130 maybe be overhauled and replaced more conveniently. When the inertial measurement unit 130 is damaged, the second circuit board 120 can be replaced in a targeted manner without the need to replace or disassemble the input/output assembly 200 at the same time, which reduces the maintenance cost and is more conducive to product maintenance.

Specifically, the input/output assembly 200 may be a light-emitting device or an imaging assembly. Each first circuit board 110 of the one or more first circuit boards 110 may be configured to be connected to at least one light-emitting device and/or at least one imaging assembly.

By electrically connecting the light-emitting devices to the one or more first circuit boards 110 independent of the second circuit board 120, the heat influence of the light-emitting devices from the surrounding environment of the inertial measurement unit 130 can be reduced to ensure that the light-emitting device works normally, therefore delaying the light decay of the light-emitting device and extending the life of the light-emitting devices.

Optionally, the light-emitting devices may specifically include one or more of a fill light device, a searchlight device, and a laser device. Specifically, the fill light device may be a camera fill light, more specifically an LED lamp or a halogen lamp, etc. By electrically connecting the camera fill light to the one or more first circuit boards 110, for example, connecting the camera fill light to the one or more first circuit boards 110 through soldering or terminals, when the one or more first circuit boards 110 supplies power to the camera fill light, the camera fill light may convert the electrical energy into optical energy, to provide auxiliary light when shooting in a low light condition.

The searchlight device may include a searchlight, and of course, may include other components including a concave mirror for condensing light. The searchlight may be electrically connected to the one or more first circuit boards 110, for example, the searchlight may be connected to the one or more first circuit boards 110 by soldering or through terminals. When the one or more first circuit boards 110 supplies power to the searchlight, the searchlight may convert electrical energy into optical energy and emit a powerful beam for remote reconnaissance.

The laser device may include a laser device. The laser device may be electrically connected to the one or more first circuit boards 110, for example, the laser device may be connected to the one or more first circuit boards 110 by soldering or through terminals. When the one or more first circuit boards 110 supplies power to the laser device, the laser device may convert electrical energy into optical energy and emit laser beams for indication.

Also, the imaging assemblies may be provided mainly for the situation where the circuit board system 100 is applied to a photographing device including a camera or video camera. By electrically connecting the imaging assemblies to the one or more first circuit boards 110 independent of the second circuit board 120, the thermal influence from the surrounding environment of the inertial measurement unit 130 maybe be reduced to ensure that the imaging assemblies can produce high-quality images normally, slow down the aging of the imaging assemblies, and extend the life of the imaging assemblies.

Optionally, the imaging assemblies may specifically include one or more of a visible light imaging assembly, a thermal imaging assembly, and an infrared light imaging assembly. Specifically, the visible light imaging assembly may specifically include a lens assembly and an image sensor optically corresponding to the lens assembly. The image sensor may be electrically connected to the one or more first circuit boards 110, for example, the image sensor may be connected to the one or more first circuit boards 110 by soldering or through terminals. The lens assembly may be mechanically connected to the one or more first circuit boards 110, or may not be directly mechanically connected. The image sensor may be used to convert the visible light captured by the lens assembly into an electrical signal proportional to the optical image, and transmit the generated electrical signal to the gimbal 300 or the movable platform for processing in time through the circuit board system 100, to realize the visible light photographing function.

Different from the aforementioned visible light imaging assembly, the sensor of the thermal imaging assembly can be an infrared detection sensor, and the infrared detection sensor may be connected to the one or more first circuit boards 110, for example, the infrared detection sensor may be connected to the one or more first circuit boards 110 by soldering or through terminals. The infrared detection sensor may be configured to convert the infrared light captured by the lens assembly into an electrical signal proportional to the optical image, and the generated electrical signal may be transmitted to the gimbal 300 or the mobile platform in time through the circuit board system 100 for processing. Correspondingly, the target may be discovered based on the temperature difference or thermal radiation between the target and the background or various parts of the target, to realize infrared detection and imaging. Therefore, the product may have convenient application functions including fire prevention, night vision, and security reconnaissance.

Different from the aforementioned visible light imaging assembly, the infrared light imaging assembly may include an infrared transmitter and an infrared detection sensor. The infrared transmitter and the infrared detection sensor may be connected to the one or more first circuit boards 110, for example, the infrared transmitter and the infrared detection sensor may be connected to the one or more first circuit boards 110 by soldering or through terminals specifically. The infrared transmitter may be configured to emit infrared light. The infrared detection sensor may be configured to receive the infrared light of the target reflection source and generate an electrical signal proportional to the optical image. The generated electrical signals may be transmitted to the gimbal 300 or the movable platform for processing in time, to realize observation and detection by actively illuminating and using the infrared light of the target reflection infrared source. Therefore, the product may have convenient application functions in night vision and security, or reconnaissance.

More preferably, the inertial measurement unit 130 may specifically include an inertial measurement sensor. The inertial measurement sensor may include a gyroscope and an accelerometer. The inertial measurement sensor may be used to detect the state parameters of the circuit board system 100 and the input/output assemblies 200 thereon, or the inertial measurement sensor may be used to detect the state parameters of the equipment where the entire circuit board system 100 is located, such as detecting the angular velocity and/or acceleration parameters of the circuit board system 100 and the input/output assemblies 200 or the equipment where the entire circuit board system is located. The parameters detected by the inertial measurement sensor may be supplied to the main control circuit board 310 of the gimbal 300 for processing, such that the main control circuit board 310 of the gimbal 300 may tune an electrical tuning system of the gimbal 300 according to the parameters provided by the inertial measurement sensor. Correspondingly, the electrical tuning system of the gimbal 300 may adjust the posture of the circuit board system 100 and the input/output assembly 200 or the above-mentioned entire device accordingly to achieve stable photographing or light supply.

### Embodiment one (illustrated in FIG. 1)

As illustrated in FIG. 1, the circuit board system 100 includes one or more first circuit boards 110 and a second circuit board 120. The one or more first circuit boards 110 and the second circuit board 120 are arranged separately.

The one or more first circuit boards 110 may be printed circuit boards, that is, PCB boards.

The second circuit board 120 may be a printed circuit board, that is, a PCB board.

The second circuit board 120 is provided with an inertial measurement unit 130, a first interface 140, and a plurality of second interfaces 150. The plurality of second interfaces 150 is electrically connected to the one or more first circuit boards 110 correspondingly. The second circuit board 120 is configured to supply power to the one or more first circuit boards 110. The inertial measurement unit 130 is electrically connected to the first interface 140, and the first interface 140 is configured to be electrically connected to the main control circuit board of the gimbal.

The number of the one or more first circuit boards 110 is multiple, and is the same as the number of the input/output assemblies 200. There is a one-to-one correspondence between the one or more first circuit boards 110 and the input/output assemblies 200. Correspondingly, the input/output assemblies 200 may not interfere with each other, and the spatial location layout of the multiple input/output assemblies 200 is not limited to a same circuit board. Therefore, the location layout of the multiple input/output assemblies 200 can be more flexible and the matching and combination of different types of the input/output assemblies 200 may be realized. For example, a light-emitting device may be matched with an imaging assembly according to needs, or a fill light device may be matched with a laser device. The product type design may be more flexible, different functional requirements may be met. The cost of modification may be extremely low. For example, replacing one circuit board 110 of the one or more first circuit boards 110 and one corresponding input/output assembly 200 on it may be sufficient, which also makes the maintenance and replacement of each input/output assembly 200 easier and more convenient.

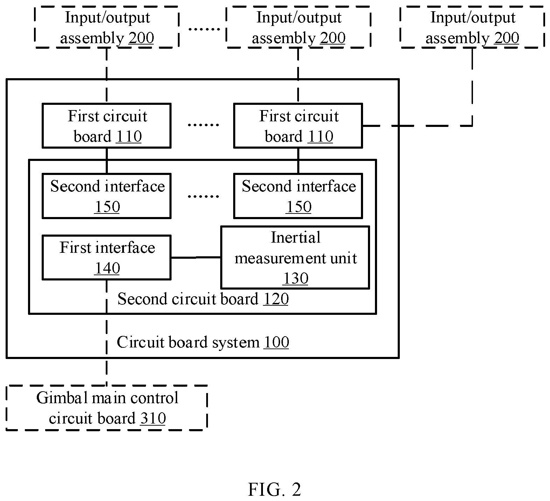

### Embodiment two (illustrated in FIG. 2)

Difference from embodiment one described above is that the number of the one or more first circuit boards 110 is less than the number of the input/output assemblies 200, and at least one first circuit board 110 is configured to be connected to two or more input/output assemblies 200.

More specifically, the number of the one or more first circuit boards 110 is multiple, and among the one or more first circuit boards 110, each of some of the one or more first circuit boards 110 is configured to be connected to a corresponding input/output assembly 200, and each of some other ones of the one or more first circuit boards 110 is configured to be connected to two or more corresponding input/output assemblies 200. Correspondingly, for an input/output assembly with a relatively large volume and a large number of parts, such as a visible light imaging assembly, a corresponding first circuit board 110 can be designed to be separately connected to the visible light imaging assembly. For input/output assemblies with a smaller volume, fewer parts, and relatively simple structure, such as fill light devices, searchlight devices or laser devices, etc., a first circuit board 110 is configured to be electrically connected with these modules, such as multiple fill light devices, or a first circuit board 110 is configured to be electrically connected to any two or three of the fill light devices, searchlight devices, or laser devices, to reduce the consumption of circuit board materials and costs. In another example, for two modules that are usually used together, such as a visible light imaging assembly and a fill light device, the visible light imaging assembly and the fill light device may be integrated on one same first circuit board 110. Therefore, the consumption of materials of the circuit boards may be reduced, and at the same time, it is also beneficial to improve the work coordination and relative position accuracy between the visible light imaging assembly and the fill light device.

Of course, the present embodiment is used as an example for illustrative purposes only and should not limit the scope of the present disclosure. According to needs, each of the one or more first circuit boards 110 may be designed to be connected to two or more input/output assemblies 200.

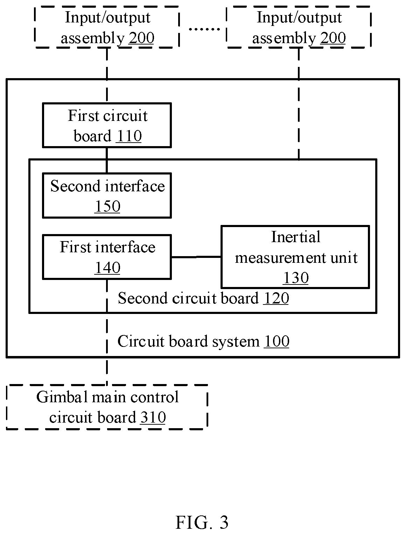

### Embodiment three (illustrated in FIG. 3)

Difference from embodiment one described above is that when the number of the input/output assemblies 200 is multiple, some of the plurality of input/output assemblies 200 are electrically connected to the one or more first circuit boards 110 and some other ones of the plurality of input/output assemblies 200 are electrically connected to the second circuit board 120.

Therefore, some of the plurality of input/output assemblies 200 that have a large mutual influence with the inertial measurement unit 130 are disposed at the one or more first circuit boards 110, and some other ones of the plurality of input/output assemblies 200 that have a small mutual influence with the inertial measurement unit 130 are disposed at the second circuit board 120, to make full use of the space of the second circuit board 120. Therefore, the total number of the circuit boards and the product cost may be reduced.

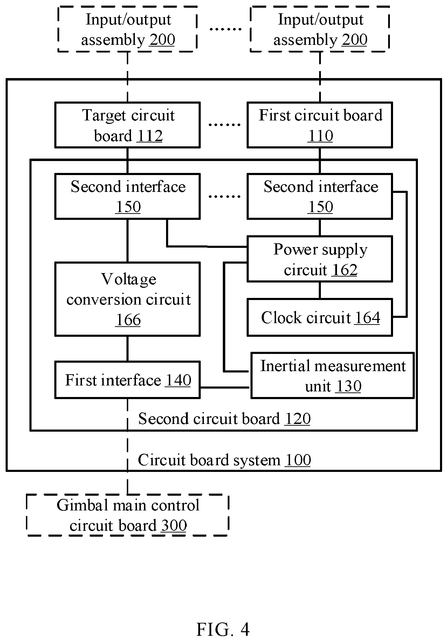

### Embodiment four (illustrated in FIG. 4)

Difference from embodiment one described above is that the second circuit board 120 is provided with a functional circuit 160. More specifically, the functional circuit 160 includes one or more of a power supply circuit 162, a voltage conversion circuit 166, a clock circuit 164.

Specifically, in an embodiment where the functional circuit 160 includes a power supply circuit 162, the power supply circuit 162 and a corresponding first circuit board 110 of the one or more first circuit boards 110 may form a direct or indirect electrical connection relationship, such that the second circuit board 120 may supply power to the corresponding first circuit board 110 corresponding to the power supply circuit 162, through the power supply circuit 162.

More specifically, the power supply circuit 162 may be electrically connected to a corresponding second interface 150 of the plurality of second interfaces 150, and may be electrically connected to the corresponding first circuit board 110, which is also connected to the corresponding second interface 150, through the corresponding second interface 150. In this way, it may be beneficial to realize the integration of the interfaces between the one or more first circuit boards 110 and the second circuit board 120. The number of wiring between the one or more first circuit boards 110 and the second circuit board 120 may be reduced. Therefore, wiring steps may be correspondingly reduced, and the assembly may be easier and faster.

Of course, the present embodiment is used as an example for illustrative purposes only and should not limit the scope of the present disclosure. According to needs, in another embodiment, the power supply circuit 162 may be not electrically connected to the corresponding first circuit board 110 through the corresponding second interface 150, but may be designed to be directly connected to the corresponding first circuit board 110.

Further, as illustrated in FIG. 4, the power supply circuit 162 on the second circuit board 120 is electrically connected to multiple second interfaces 150, to realize supplying power to multiple corresponding first circuit boards 110 through the multiple corresponding second interfaces 150. It may be beneficial for the integration and miniaturization of the second circuit board 120.

Of course, the present embodiment is used as an example for illustrative purposes only and should not limit the scope of the present disclosure. According to needs, in another embodiment, a plurality of power supply circuits 162 may be disposed on the second circuit board. The plurality of power supply circuits 162 may be in a one-to-one correspondence with the plurality of second interfaces 150, such that each of the plurality of power supply circuits 162 supplies power to a corresponding first circuit board of the one or more first circuit boards 110.

For embodiments where the functional circuit 160 includes clock circuits 164, preferably, the functional circuit 160 is configured to include at least one clock circuit 164, and the at least one clock circuit 164 is used to transmit a time signal to at least one corresponding first circuit board 110 of the one or more first circuit boards 110.

It is understandable that the input/output assembly 200 can be subdivided into two types: an input/output assembly with its own clock function and an input/output assembly without its own clock function. For the input/output assembly that does not have a clock function, a clock circuit 164 may be set on the second circuit board 120, and the clock circuit 164 may transmit time signal to a preset first circuit board 110. The preset first circuit board 100 is a first circuit board for connecting with the input/output assembly that does not have a clock function.

More specifically, the clock circuit 164 is electrically connected to a corresponding second interface 150 of the plurality of second interfaces 150, and is electrically connected to a first circuit board 110 connected to the corresponding second interface 150 through the corresponding second interface 150. Therefore, it may be beneficial to realize the integration of the interfaces between the one or more first circuit boards 110 and the second circuit board 120. The number of wirings between the one or more first circuit boards 110 and the second circuit board 120 may be reduced, the wiring steps may be correspondingly reduced, and the assembly may be easier and faster.

Of course, the present embodiment is used as an example for illustrative purposes only and should not limit the scope of the present disclosure. According to needs, in another embodiment the clock circuit 164 may not be electrically connected to the corresponding first circuit board 110 through a second interface 150, while the clock circuit 164 and the corresponding first circuit board 110 may be connected through direct wiring.

More preferably, as shown in FIG. 4, the power supply circuit 162 on the second circuit board 120 is also electrically connected to the clock circuit 164, the inertial measurement unit 130, etc., on the second circuit board 120, and is used to supply power to the clock circuit 164, the inertial measurement unit 130, etc.

In one embodiment where the functional circuit 160 includes a voltage conversion circuit 166, the one or more first circuit boards 110 includes at least one target circuit board 112. An electrical signal corresponding to the at least one target circuit board 112 has a voltage different from a voltage of electrical signals corresponding to others of the one or more first circuit boards 110 except for the at least one target circuit board 112. The voltage conversion circuit 166 is configured to perform voltage conversion on the electrical signal between the second circuit board 120 and the at least one target circuit board 112. Therefore, through the voltage conversion, the amplitude of the electrical signal from the second circuit board 120 is compatible with the voltage required by an input/output assembly 200 connected to the at least one target circuit board 112. Correspondingly, with the voltage conversion circuit 166, the second circuit board 220 can be used for different input/output assemblies 200 and the corresponding first circuit boards 110, thereby facilitating the realization of the application of the circuit board system in different scenarios. It can be understood that by setting the corresponding input/output assemblies 200, the voltage of the corresponding electrical signal can be controlled. If the voltage of the corresponding electrical signal is controlled within a certain range, the voltage conversion circuit 166 may not be needed.

Of course, the present embodiment is used as an example for illustrative purposes only and should not limit the scope of the present disclosure. According to needs, in another embodiment, for performing voltage conversion on the electrical signal between the second circuit board 120 and the at least one target circuit board 112, the voltage conversion circuit 166 may be disposed on the one or more first circuit boards 110.

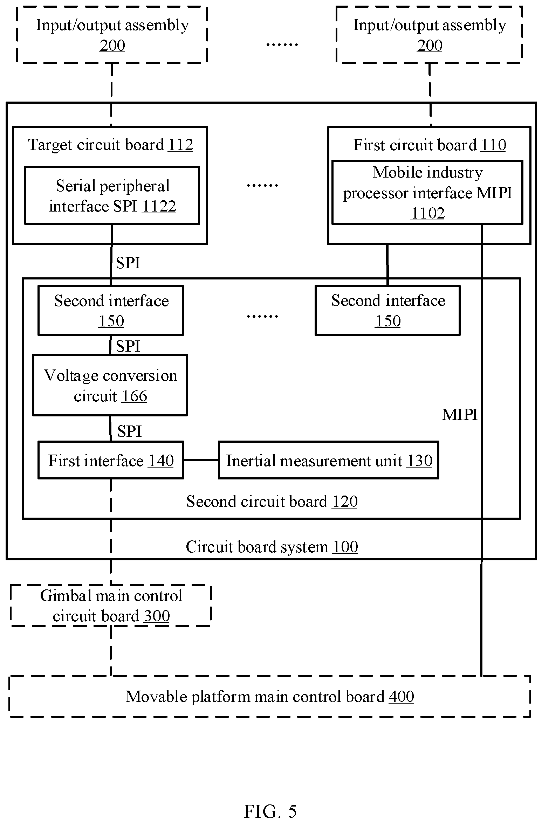

### Embodiment five (illustrated in FIG. 5)

The present embodiment includes features of embodiment four and further sets forth that the at least one target circuit board 112 is provided with a serial peripheral interface SPI 1122, and the voltage conversion circuit 166 is electrically connected to the serial peripheral interface SPI 1122.

It should be understood that the serial peripheral interface (SPI) bus system is a synchronous serial peripheral interface, which could enable a microcontroller unit (MCU) to communicate with various peripheral devices in a serial manner to exchange information.

More specifically, the serial peripheral interface SPI 1122 is connected to a corresponding second interface 150 of the plurality of second interfaces 150, and the voltage conversion circuit 166 is electrically connected to the corresponding second interface 150, to realize electrical conduction between the voltage conversion circuit 166 and the serial peripheral interface SPI 1122.

Further, the voltage conversion circuit 166 is electrically connected to the first interface 140 to transmit an electrical signal from the serial peripheral interface SPI 1122 to the main control circuit board 310 of the gimbal 300, such that the main control board 400 of the movable platform can obtain the electrical signal from the serial peripheral interface SPI 1122 through the main control circuit board 310 of the gimbal 300.

Correspondingly, communication signal flow between the input/output assembly 200 electrically connected to the target circuit board 112 and the main control board 400 of the movable platform is: the electrical signals formed by the input/output assembly 200 electrically connected to the target circuit board 112 sequentially pass through the corresponding first circuit board 110, the corresponding second interface 150, the voltage conversion circuit 166, and the first interface 140, and then reach the main control circuit board 310 of the gimbal 300. The main control circuit board 310 of the gimbal 300 further transfer the signal to the main control board of the movable platform. Therefore, the interface of the main control board 400 of the movable platform may not be additionally occupied, and the volume and wiring assembly steps of the main control board 400 of the movable platform may be simplified.

Of course, the present embodiment is used as an example for illustrative purposes only and should not limit the scope of the present disclosure. According to needs, in another embodiment, the voltage conversion circuit 166 and the corresponding first circuit board 110 may be electrically connected by direct wiring instead of using the second interface 150 as a medium. In some other embodiments, when the main control board 400 of the movable platform is capable of accommodating a plurality of interfaces, the electrical signals formed by the input/output assembly 200 electrically connected to the target circuit board 112 may be transmitted to the main control board 400 of the movable platform through the serial peripheral interface SPI 1122. The present disclosure has no limit on this and the system can be configured according to actual needs.

Further, in the present embodiment, at least one first circuit board 110 of the one or more first circuit boards 110 is configured to include a mobile industry processor interface (MIPI) 1102. The mobile industry processor interface MIPI 1102 is configured to be electrically connected to the main control board 400 of the movable platform. The gimbal 300 is carried by the movable platform. The input/output assembly 200 communicates with the main control board 400 of the movable platform directly through the corresponding first circuit board 110. The accuracy and transmission efficiency may be improved.

More specifically, as illustrated in FIG. 5, the mobile industry processor interface MIPI 1102 and the main control board 400 of the movable platform are connected by wire. In some other embodiments, of course, the mobile industry processor interface MIPI 1102 and the main control board 400 of the movable platform may be designed to be connected with each other through wireless communication.

Preferably, the input/output assembly 200 connected to the first circuit board 110 provided with the mobile industry processor interface MIPI 1102 is an imaging assembly, including one or more of a visible light imaging assembly, a thermal imaging assembly, an IR light imaging assembly.

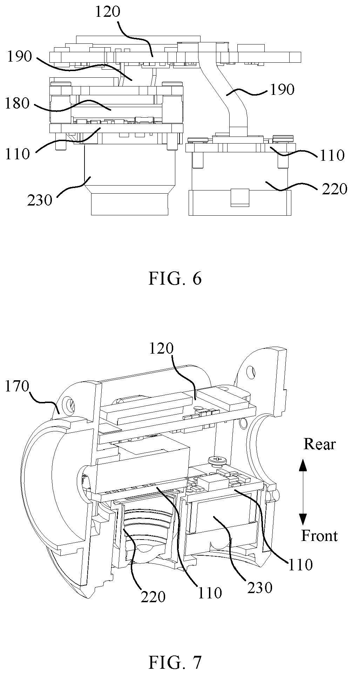

### Embodiment six (illustrated in FIG. 6)

The present embodiment includes features of embodiment one and further sets forth that a second interface 150 of the plurality of second interfaces 150 and a corresponding first circuit board of the one or more first circuit boards 110 are connected with each other through a flat cable 190. Correspondingly, the second interface 150 is specifically a wiring port for connecting with the flat cable 190, such as a terminal.

Of course, the present embodiment is used as an example for illustrative purposes only and should not limit the scope of the present disclosure. It should be understood to those skilled in the field that the second interface 150 is used for signal transmission between the corresponding first circuit board 110 and the second circuit board 120. In another embodiment, the second interface 150 may be also configured as a wireless communication module for establishing wireless communication with the corresponding first circuit board 110.

### Embodiment seven (illustrated in FIG. 7)

The present embodiment includes features of embodiment one and further sets forth that the circuit board system 100 includes a housing 170. Preferably, the housing 170 is provided with a connection member for connecting the housing 170 to an inner frame of the gimbal 300. The connection member is used to realize detachable or non-detachable connection between the housing 170 and the gimbal 300. For example, the connection member may include specifically, a buckle, a lock buckle, a clamp, etc., provided on the housing 170 and can be used to assemble the housing 170 on the gimbal 300.

Of course, the present embodiment is used as an example for illustrative purpose only and should not limit the scope of the present disclosure. According to actual needs, in another embodiment, an additional bracket may be provided, and the housing 170 may be mounted on the bracket. A connecting portion may be provided on the bracket for connecting and assembling the bracket and the gimbal 300, thereby realizing indirect assembly between the housing 170 and the gimbal 300.

The housing 170 has an accommodation space. The second circuit board 120 and the one or more first circuit boards 110 are disposed in the accommodation space. In the present embodiment, the second circuit board 120 and the one or more first circuit boards 110 are disposed in the accommodation space, and the housing 170 is directly or indirectly assembled on the gimbal 300. The structure may protect the circuit boards from being destroyed.

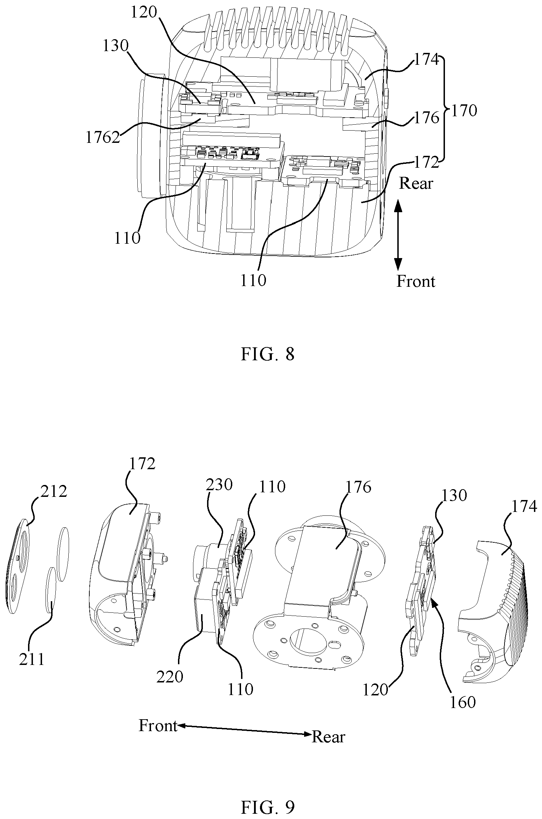

### Embodiment eight (illustrated in FIG. 8 to FIG. 13)

In addition to the features of embodiment one, as illustrated in FIG. 8, FIG. 9, and FIG. 10, the housing 170 includes a front housing 172, a rear housing 174, and a middle frame 176. The middle frame 176 is located between the front housing 172 and the rear housing 174, and is connected to the front housing 172 and the rear housing 174. The space enclosed by the front housing 172 and the middle frame 176 is provided with the one or more first circuit boards 110, and the space enclosed by the rear housing 174 and the middle frame 176 is provided with the second circuit board 120. Therefore, the one or more first circuit boards 110 and the second circuit board 120 can have a relatively independent working environment, which can prevent the input/output assemblies 200 on the one or more first circuit boards and the inertial measurement unit 130 on the second circuit board 120 from interfering with each other. The product performance may be improved.

More preferably, the one or more first circuit boards 110 are connected to the front housing 172 and the second circuit board 120 is connected to the middle frame 176. This design makes the second circuit board 120 located in the middle position between the front and rear ends of the housing 170, which is more conducive to improving the accuracy of the inertial measurement unit 130 for detecting the posture of the entire circuit board system 100. Further, through the structure of this design, the assembly process of the product may include: after the one or more first circuit boards 110 are mounted on the front housing 172, mounting the middle frame 176 at a structure formed by the one or more first circuit boards 110 and the front housing 172, and then mounting the second circuit board 120 on the middle frame 176 such that the plurality of second interfaces 150 of the second circuit board 120 is connected to the one or more first circuit boards 110 and the front housings 172. By using the above assembly step, the flat cable 190 between the one or more first circuit boards 110 and the second circuit board 120 may be the shortest, which can reduce the interference effect of the flat cable 190 on the inertial measurement unit 130 and improve the working accuracy of the inertial measurement unit 130.

Further, as illustrated in FIG. 8, FIG. 9, and FIG. 10, the present embodiment includes two first circuit boards 110, and each of the two first circuit boards 110 is connected to a corresponding input/output assembly 200. One of the two first circuit boards 110 is connected to the visible light imaging assembly 230, and another one is connected to the thermal imaging assembly 220. The two first circuit boards 110 are arranged side by side and in parallel, such that the orientation of the two input/output assemblies 200 is the same and parallel. Such a design can help ensure that the visual fields of the visible light imaging assembly 230 and the thermal imaging assembly 220 overlap as much as possible, to achieve dual-light shooting and dual-light fusion.

For example, when there are two input/output assembly 200, one input/output assembly 200 may be a visible light camera assembly 230, and another input/output assembly 200 may be a thermal imaging camera assembly 220. In the process of chasing a car at night, because the brightness of the night environment is too dark, to identify a license plate number of the preceding vehicle, it may be needed to use the thermal imaging camera assembly 220 to take a thermal imaging image, and the visible light camera assembly 230 to take a visible-light image. Subsequently, the outline of the numbers or letters in the license plate may be recognized based on the visible light image, and the colors of the numbers or letters in the license plate are filled in based on the thermal imaging image, such that the license plate number is recognized. Through the parallel arrangement of the two first circuit boards 110 corresponding to the visible light imaging assembly 230 and the thermal imaging assembly 220, the field of view between the thermal imaging camera assembly 220 and the visible light camera assembly 230 can be maximized as much as possible. Otherwise, it may happen that the visible light camera assembly 230 captures all the license plates, but the thermal imaging camera assembly 220 only captures a part of the license plate or does not capture the license plate, resulting in the inability to perform feature matching between the visible light image and the thermal imaging image and the license plate number cannot be recognized.

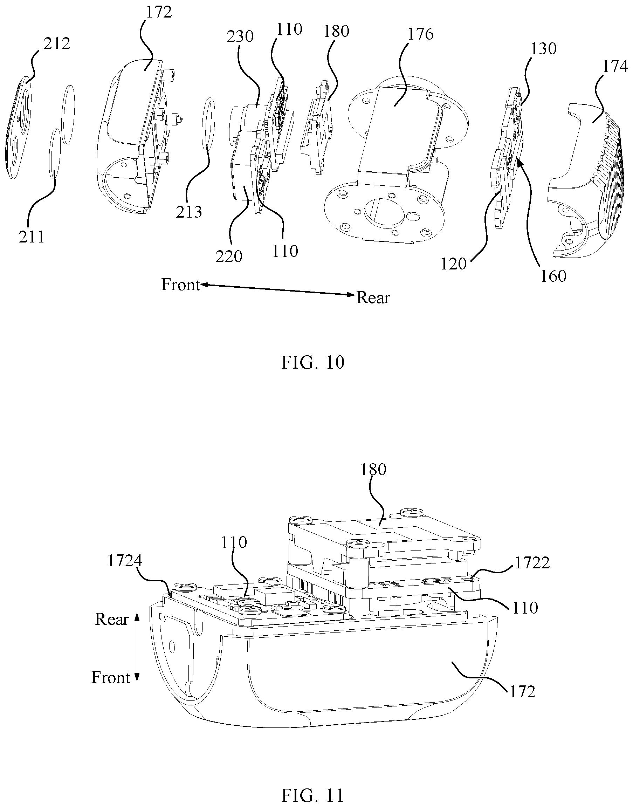

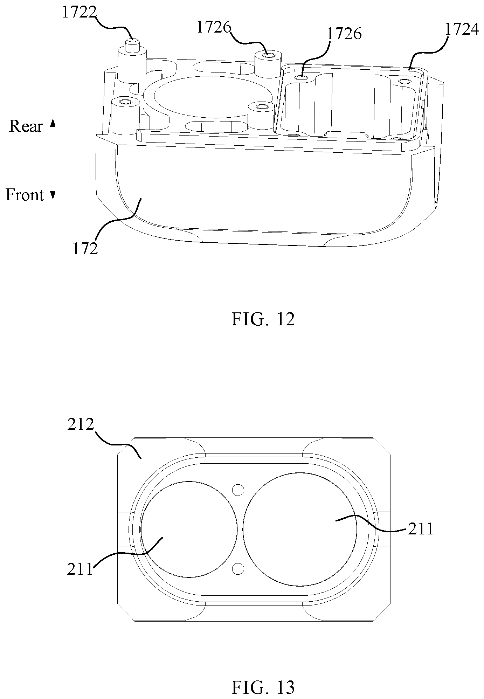

More specifically, as shown in FIG. 11 and FIG. 12, the rear end of the front housing 172 is provided with a positioning post 1722 and a screw hole 1726, and a first circuit board 110 of the two first circuit boards 110 is provided with a through hole. The positioning post 1722 penetrates the through hole to realize the positioning between the first circuit board 110 and the front housing 172. Also, a screw is driven into the screw holes 1726 to fasten the front housing 172 and the first circuit board 110, restricting the first circuit board 110 from coming out the positioning post 1722. Therefore, the first circuit board 110 and the front housing 172 are fixed.

The rear end of the front housing 172 is also provided with a fixing groove 1724 and a screw hole 1726. The contour of another first circuit board 110 of the two first circuit boards 110 is adapted to the fixing groove 1724, such that the first circuit board 110 is embedded in the fixing groove 1724 to realize positioning between the first circuit board 110 and the front housing 172. In addition, the screw is driven into the screw holes 1726 to fasten the front housing 172 and the first circuit board 110 to restrict the first circuit board 110 from coming out of the fixing groove 1724, realizing fixing of the first circuit board 110 to the front housing172.

Further, as shown in FIG. 10, a sealing ring 213 is provided between the front housing 172 and the input/output assemblies 200. The sealing ring 213 functions as a seal, cushioning and shock absorption, to improves the photographing effect.

Also, the front end of the front housing 172 is provided with a lens frame 212. As shown in FIG. 13, the lens frame 212 is provided with two light-transmitting holes, and the front housing 172 is provided with two light-passing holes. The two light-transmitting holes and the two light-passing holes have a one-to-one correspondence. The two light-transmitting holes or the two light-passing holes are respectively packaged with lenses 211, and the two lenses 211 are opposite to the two input/output assemblies 200.

The second circuit board 120 is located on the rear side of the two first circuit boards 110 and is opposite to the two first circuit boards 110, such that the second circuit board 120 and the two first circuit boards 110 divide the space in the housing 170 into three segments. The part of the middle frame 176 corresponding to the inertial measurement unit 130 is provided with a damping material to dampen the inertial measurement unit 130 and reduce the influence of high frequency vibration on the inertial measurement unit 130. Therefore, the measurement accuracy of the inertial measurement unit 130 may be improved.

Preferably, the middle frame 176 is provided with a positioning groove 1762, and the damping material is filled in the positioning groove 1762. The positioning groove 1762 plays a role in positioning and limiting the damping material, ensuring that the damping material is accurately aligned with the inertial measurement unit 130, and ensuring shock absorption reliability.

Preferably, as shown in FIG. 10, a heat sink 180 is provided at a portion of the first circuit board 110 corresponding to the inertial measurement unit 130.

Preferably, a functional circuit 160 is provided on the first circuit board 110. More specifically, the functional circuit 160 includes one or more of a power supply circuit 162, a voltage conversion circuit 166, and a clock circuit 164. As shown in FIG. 10, the inertial measurement unit 130 and the functional circuit 160 are arranged far away from each other to reduce the influence of the working environment temperature of the inertial measurement unit 130 on the functional circuit 160, and to ensure the normal operation of the functional circuit 160. As the preferred technical solution of this design, as shown in Figure 10, it is further preferred that the functional circuit 160 is located in the middle of the second circuit board 120, and the inertial measurement unit 130 is adjacent to the edge of the second circuit board 120.

### Embodiment nine

Different from embodiment eight, the housing 170 includes a front housing 172, a rear housing 174, and a middle frame 176. The middle frame 176 is located between the front housing 172 and the rear housing 174 and is connected to the front housing 172 and the rear housing 174. Some of the one or more first circuit boards 110 are disposed in a space enclosed by the front housing 172 and the middle frame 176. Some other ones of the one or more first circuit boards 110 and the second circuit board 120 are disposed in a space enclosed by the rear housing 174 and the middle frame 176.

Further, some of the one or more first circuit boards 110 are connected to the front housing 172, and some other ones of the one or more first circuit boards 110 are connected to the rear housing 174. The second circuit board 120 is connected to the middle frame 176.

For example, taking two first circuit boards 110 as an example, the two first circuit boards 110 are arranged opposite to each other, and the input/output assemblies 200 are located on opposite sides of the two first circuit boards 110, such that the orientations of the two input/output assemblies 200 connected to the two first circuit boards 110 are opposite to each other. The second circuit board 120 is located between the two first circuit boards 110.

One of the two first circuit boards 110 with the input/output assembly 200 facing the front side is connected to the front housing 172, and another one of the two first circuit boards 110 with the input/output assembly 200 facing the rear side is connected to the rear housing 174. The second circuit board 120 is connected to 176. In the present embodiment, the two input/output assemblies 200 work in two fields of view facing opposite directions, which can increase the angle of view for shooting or reconnaissance, may have a wider collection range, and can also relatively reduce the operating frequency of the gimbal 300 to improve product endurance.

Preferably, one of the two first circuit boards 110 is used to be connected to a visible light imaging assembly, and another of the two first circuit boards 110 is used to be connected to a thermal imaging assembly.

Embodiments of the second aspect of the present disclosure provide a photographing device including the circuit board system 100 provided by any embodiment of the first aspect. Input/output assemblies 200 connected to one or more first circuit boards 110 of the circuit board system 100 at least include an imaging assembly.

The photographing device provided by the present disclosure is provided with the circuit board system 100 described in any of the above-described embodiments, thereby having all the above beneficial effects, which will not be repeated here.

Optionally, the photographing device may be a camera or a video recorder.

More specifically, the photographing device may be a dual-lens camera. The dual-lens camera specifically may include, for example, a visible light camera, a thermal imaging dual-lens camera, and may also include a visible light camera and a fill light.

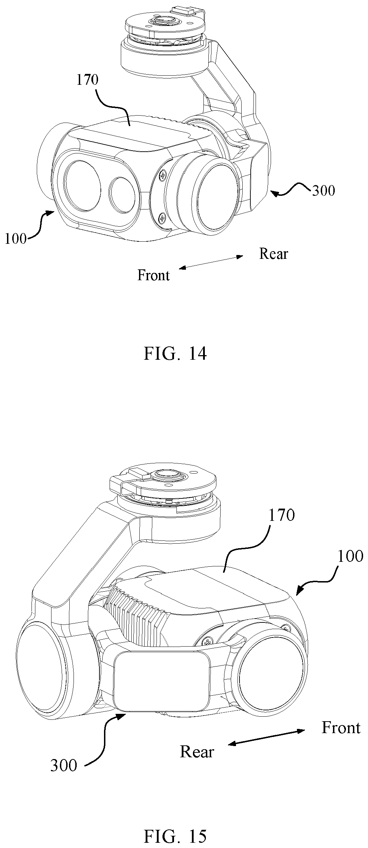

As shown in FIG. 14 and FIG. 15, the gimbal assembly provided by the embodiments of the third aspect of the present disclosure includes a gimbal 300 and a circuit board system 100 provided by any of the above-described embodiments.

The gimbal assembly provided in this embodiment may be provided with the circuit board system 100 described in any of the above embodiments, thereby having all the above beneficial effects, which will not be repeated here.

Optionally, the gimbal 300 of the gimbal assembly is a water surface, air, or land robotic gimbal, or a handheld gimbal.

The movable platform provided by various embodiments of the fourth aspect of the present disclosure may include: a body; and a circuit board system 100 provided by any of the above-described embodiments.

The movable platform provided in the present disclosure may be provided with the circuit board system 100 described in any one of the above embodiments, thereby having all the above beneficial effects, which will not be repeated here.

Optionally, the vehicle body of the movable platform may be a water surface robot, an aerial robot, or a land robot. Specifically, the aerial robot may be, for example, an unmanned aerial vehicle.

In summary, in the circuit board system provided by the present disclosure, the second circuit board and the one or more first circuit boards are arranged independently. Therefore, the mutual interference between the input/output assemblies electrically connected to the one or more first circuit boards and the inertial measurement unit may be greatly reduced. Further, the spatial location layout of the inertial measurement unit and the input/output assemblies may be not limited to the same circuit board. Correspondingly, the location layout between the inertial measurement unit and the input/output assemblies may be more flexible, and more space can be provided near the inertial measurement unit, to handle the external interference and working environment requirements of the inertial measurement unit. Performance of the inertial measurement unit and the input/output assemblies, and the comprehensive improvement of product performance, may be improved. At the same time, the workload of hardware development may be reduced, the compact and reasonable space layout between product components may be improved, which is conducive to the development of miniaturization and light weight of the product. Further, by separating the second circuit board with the inertial measurement unit from the one or more first circuit boards that are electrically connected to the input/output assemblies, the inertial measurement unit can be overhauled and replaced more conveniently. For example, when the inertial measurement unit is damaged, the second circuit board can be replaced without the need to replace or disassemble input/output assemblies at the same time. The maintenance cost may be lower, and the product maintenance may be improved.

In the present disclosure, the terms including "first," "second," and "third" are only used for descriptive purposes, and cannot be understood as indicating or implying relative importance. The term "plurality" refers to two or more, unless otherwise clearly defined. The terms "installed," "connection," "connected," "fixed" and other terms should be understood in a broad sense. For example, "connection" can be a fixed connection, a detachable connection, or an integral connection, "connected" can mean directly connected or indirectly connected through an intermediary. For those of ordinary skill in the art, the specific meaning of the above-mentioned terms in the present disclosure can be understood according to specific circumstances.

In the description of the present disclosure, it should be understood that the orientation or positional relationship indicated by the terms "front," "rear," etc. is based on the orientation or positional relationship shown in the drawings, and is only for the convenience of describing the present disclosure and simplifying the description. It does not indicate or imply that the described device or unit must have a specific direction, be configured and operate in a specific orientation, and therefore, it cannot be understood as a limitation of the present disclosure.

In the description of this specification, the description of the terms "one embodiment," "some embodiments," "specific embodiment," etc. means that specific features, structures, materials, or characteristics described in conjunction with the embodiment or example are included in the present disclosure In at least one embodiment or example. In this specification, the schematic representations of the above-mentioned terms do not necessarily refer to the same embodiment or example. Moreover, the described specific features, structures, materials or characteristics may be combined in any one or more embodiments or examples in a suitable manner. The above are only preferred embodiments of the present disclosure and are not used to limit the present disclosure. For those skilled in the art, the present disclosure can have various modifications and changes. Any modification, equivalent replacement, improvement, etc., made within the spirit and principle of the present disclosure shall be included in the protection scope of the present disclosure.

Preferred embodiments of the present disclosure are described above, which are not intended to limit the present disclosure. For those skilled in the art, the present disclosure can have various modifications and changes. Any modification, equivalent replacement, improvement, etc. made within the spirit and principle of the present disclosure should be included in the scope of the present disclosure.

## Claims

1. A circuit board system configured to be fixed at an inner frame of a gimbal, comprising:
one or more first circuit boards, wherein each first circuit board is configured to be connected to at least one input/output assembly capable of receiving/transmitting optical signal;
a second circuit board disposed independently from the one or more first circuit boards;
wherein the second circuit board is provided with an inertial measurement unit, a first interface, and one or more second interfaces, the one or more second interfaces are correspondingly electrically connected to the one or more first circuit boards, the second circuit board is configured to supply power to the one or more first circuit boards, the inertial measurement unit is electrically connected to the first interface, the first interface is configured to be electrically connected to a main control circuit board of the gimbal.

2. The circuit board system according to claim 1, wherein each of the one or more first circuit boards is configured to be connected to at least one light-emitting device, and/or at least one imaging assembly.

3. The circuit board system according to claim 2, wherein:
the at least one light-emitting device includes one or more of a fill light device, a searchlight device, a laser device; and/or
the at least one imaging assembly includes one or more of a visible light imaging assembly, a thermal imaging assembly, an infrared light imaging assembly.

4. The circuit board system according to claim 1, wherein:
a number of the one or more first circuit boards is the same as a number of the input/output assemblies, and there is a one-to-one correspondence between the one or more first circuit boards and the input/output assemblies.

5. The circuit board system according to claim 1, wherein:
a number of the one or more first circuit boards is less than a number of the input/output assemblies, and at least one first circuit board of the one or more first circuit boards is configured to be connected to two or more input/output assemblies.

6. The circuit board system according to claim 1, wherein:
when there are a plurality of input/output assemblies, the one or more first circuit boards are configured to be connected to some of the input/output assemblies, and the second circuit board is configured to be connected to some other ones of the input/output assemblies.

7. The circuit board system according to claim 1, wherein:
a number of the one or more first circuit boards is two and each of the two first circuit boards is connected to a corresponding input/output assembly;
the two first circuit boards are arranged in parallel, such that the orientations of the two input/output assemblies are the same and parallel.

8. The circuit board system according to claim 7, wherein:
one of the two first circuit boards is configured to be connected to a visible light imaging assembly and another one of the two first circuit boards is configured to be connected to a thermal imaging assembly.

9. The circuit board system according to claim 1, wherein:
a number of the one or more first circuit boards is two, and the two first circuit boards are arranged opposite to each other, such that the input/output assemblies connected to the two first circuit boards have opposite orientations.

10. The circuit board system to claim 9, wherein the second circuit board is disposed between the two first circuit boards.

11. The circuit board system according to claim 1, wherein:
the second circuit board is provided with a functional circuit, the inertial measurement unit and the functional circuit are arranged to be away from each other.

12. The circuit board system according to claim 11, wherein the functional circuit is disposed at a center of the second circuit board, the inertial measurement unit is disposed close to an edge of the second circuit board.

13. The circuit board system according to claim 11, wherein:
the functional circuit includes a power supply circuit, the second circuit board supplies power to the one or more first circuit boards through the power supply circuit.

14. The circuit board system according to claim 11, wherein the functional circuit includes at least one clock circuit, the at least one clock circuit is configured to transmit a time signal to at least one of the one or more first circuit boards.

15. The circuit board system according to claim 11, wherein:
the functional circuit includes a voltage conversion circuit, the voltage conversion circuit is configured to perform voltage conversion on electrical signals between the second circuit board and a target circuit board;
at least one of the one or more first circuit boards is the target circuit board, voltage of the electrical signal corresponding to the target circuit board is different from voltage of the electrical signal corresponding to first circuit boards other than the target circuit board in the one or more first circuit boards.

16. The circuit board system according to claim 15, wherein:
the target circuit board is provided with a serial peripheral interface, the voltage conversion circuit is electrically connected to the serial peripheral interface.

17. The circuit board system according to claim 15, wherein:
at least one of the one or more first circuit boards is provided with a mobile industry processor interface, the mobile industry processor interface is used to be electrically connected to a main control board of a movable platform; the gimbal is carried by the movable platform.

18. The circuit board system according to claim 16, wherein:
the voltage conversion circuit is electrically connected to the first interface, is configured to transmit the electrical signal output by the serial peripheral interface to the main control circuit board of the gimbal through the first interface, such that the main control board of the movable platform can obtain the electrical signal output by the serial peripheral interface from the main control circuit board of the gimbal.

19. The circuit board system according to claim 1, further comprising:
a housing, the housing includes an accommodation space, the second circuit board and the one or more first circuit boards are disposed in the accommodation space.

20. The circuit board system according to claim 19, wherein:
the housing includes a front housing, a rear housing, and a middle frame, the middle frame is located between the front housing and the rear housing, and is connected to the front housing and the rear housing, the one or more first circuit boards are disposed in a space enclosed by the front housing and the middle frame, the second circuit board is disposed in a space enclosed by the rear housing and the middle frame.

21. The circuit board system according to claim 20, wherein:
the one or more first circuit boards are connected to the front housing, the second circuit board is connected to the middle frame.

22. The circuit board system according to claim 19, wherein:
the housing includes a front housing, a rear housing, and a middle frame, the middle frame is located between the front housing and the rear housing, and is connected to the front housing and the rear housing, some of the one or more first circuit boards are disposed in a space enclosed by the front housing and the middle frame, some other ones of the one or more first circuit boards and the second circuit board are disposed in a space enclosed by the rear housing and the middle frame.

23. The circuit board system according to claim 22, wherein:
some of the one or more first circuit boards are connected to the front housing, some other ones of the one or more first circuit boards are connected to the rear housing, the second circuit board is connected to the middle frame.

24. The circuit board system according to claim 20 or claim 23, further comprising:
a damping material, the damping material is disposed at a position of the middle frame corresponding to the inertial measurement unit.

25. The circuit board system according to claim 24, wherein the middle frame is provided with a positioning groove, the damping material is filled in the positioning groove.

26. A photographing device, comprising the circuit board system according to any one of claims 1-25, the input/output assemblies connected to the one or more first circuit boards of the circuit board system at least include an imaging assembly.

27. A gimbal assembly, comprising a gimbal and the circuit board system according to any one of claims 1-25.

28. A movable platform, comprising:
a vehicle body;
the gimbal assembly according to claim 27, the gimbal of the gimbal assembly is connected to the vehicle body.
